# EUROPEAN PATENT APPLICATION

(11) **EP 1 863 327 A1**
(43) Date of publication of application: **05.12.2007**
(21) Application number: 05766427.8
(22) Date of filing: 21.07.2005
(51) Int. Cl.: H05K 3/10, H05K 1/14, H05K 3/36

(54) **PROCESS FOR PRODUCING WIRING BOARD, AND WIRING BOARD**

(30) Priority: 22.03.2005 JP 2005082350; 18.05.2005 JP 2005145741
(71) Applicant: Cluster Technology Co., Ltd, Higashiosaka-shi, Osaka 577-0836 (JP)
(72) Inventor: FUJIMOTO, Takayoshi, Cluster Technology Co., Ltd., Higashiosaka-shi, Osaka 5770836 (JP); KITAOKA, Kenji, Cluster Technology Co., Ltd., Higashiosaka-shi, Osaka 5770836 (JP)
(74) Representative: Leyh, Hans
(86) International application number: PCT/JP2005/013368
(87) International publication number: WO 2006/100790

(57) **Abstract**

A wiring circuit board and a method of producing the same are provided in which a desired pattern of wiring is provided at higher density while permitting no overflow from the grooves of an electroless plating catalyst containing solution and an electric conductor forming liquid such as silver ink.

The pattern of electric conductor is deposited by applying the electric conductor forming liquid into the grooves provided in a substrate and distributing the same along the grooves with the action of capillarity. The method starts with patterning the grooves in the surface of the substrate (S1), applying the electric conductor forming liquid into the grooves (S2), and coating the surface of the substrate with a layer of repellent liquid which is lower in the affinity with the electric conductor forming liquid (S3). This is followed by cleaning at least the grooves (S4) and then filling the grooves with the electric conductor forming liquid once again (S5). The electric conductor forming liquid applied into the grooves is then distributed throughout the grooves by the action of capillarity. When silver ink is used, the pattern of electric conductor is produced by repeating an action of applying and drying a number of times. Alternatively, the patter of electric conductor can be produced by an electroless plating technique or a combination of an electroless plating technique and an electro-plating technique for separating an electrical conductive material form the electric conductor forming liquid.

## Description

### Technical Field

The present invention relates to a wiring circuit board and a method of producing the same. More particularly, the present invention relates to a wiring circuit board producing method for applying an electric conductor forming liquid into grooves provided in a substrate, filling the grooves with the electric conductor forming liquid by the action of capillarity, and converting the electric conductor forming liquid into a pattern of conductor at the succeeding step and a wiring circuit board produced by the foregoing method.

### Background Art

Such a wiring circuit board producing method is known as disclosed in Patent Citation 1. In the citation, a pattern of fine grooves are provided in a substrate with the use of dies and filled with electrically conductive ink which is an electrically conductive material to develop the pattern of wiring. A similar method is known as disclosed in Patent Citation 2.
Patent Citation 1: Japanese Patent Laid-open Publication No. 2004-356255
Patent Citation 2: Japanese Patent Laid-open Publication No. 2005-50969

The former allows the wiring to be 50 µm or narrower in the width as have been patterned with the use of an ink jet head having a fine nozzle from which the electrically conductor forming liquid or electrically conductive ink is applied (See paragraphs 0022 and 0047). However, when the electrically conductive ink is applied into the grooves which is very narrow in the width, it may overflow and spill from the grooves, resulting in non-uniformity in the pattern of electric conductor.

### Disclosure of the Invention

### (Problems that the Invention is to solve)

It is hence an object of the present invention in view of the foregoing aspects of the prior art to provide a wiring circuit board and a wiring circuit board producing method in which the electric conductor forming liquid such as electrically conductive ink is prevented from overflowing and spilling from the grooves for patterning the wiring at higher density while its consumption is minimized.

### (Means for solving the Problems)

According to a first feature of the present invention for achievement of the object, a wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor is characterized by patterning the grooves in the surface of the substrate, filling the grooves with the electric conductor forming liquid, providing on the surface of the substrate a repellent liquid layer which is lower in the affinity with the electric conductor forming liquid, cleaning at least the grooves, and applying further the electric conductor forming liquid into the grooves.

According to a second feature of the present invention, the wiring circuit board producing method of the first feature may be modified by patterning the grooves in the surface of the substrate, applying a temporal liquid protective material into the grooves, providing on the surface of the substrate a repellent liquid layer which is lower in the affinity with the electric conductor forming liquid, cleaning at least the grooves to remove a portion of the repellent liquid layer provided over the temporal protective material, and filling the grooves with the electric conductor forming liquid.

According to a third feature of the present invention, the wiring circuit board producing method of the first feature may be modified by patterning the grooves in the surface of the substrate, applying into the grooves a protective material which is higher in the affinity with the electric conductor forming liquid, providing on the surface of the substrate a repellent liquid layer which is lower in the affinity with the electric conductor forming liquid, cleaning at least the grooves, and applying further the electric conductor forming liquid into the grooves.

According to a fourth feature of the present invention, the wiring circuit board producing method of the first feature may be modified by providing on the surface of the substrate a repellent liquid layer which is lower in the affinity with the electric conductor forming liquid, patterning the grooves in the surface of the substrate, and filling the grooves with the electric conductor forming liquid.

According to a fifth feature of the present invention, the wiring circuit board producing method of the first feature may be modified by patterning the grooves in the surface of the substrate so that their inner wall has at least partially rough surfaces thereof provided continuously and lengthwisely, providing on the surface of the substrate a repellent liquid layer which is lower in the affinity with the electric conductor forming liquid, and filling the grooves with the electric conductor forming liquid.

The wiring circuit board producing method according to any of the preceding features may be modified in which the electric conductor forming liquid is an electroless plating catalyst containing solution and the post-process involves separating an electrically conductive material from the solution at the opening of the grooves by an electroless plating technique for developing the pattern of electric conductor. Alternatively, thepost-processmay involve separating an electrically conductive material from the solution at the opening of the grooves by a combination of the electroless plating technique and an electro-plating technique following the electroless plating technique for developing the pattern of electric conductor.

The wiring circuit board producing method according to any of the preceding features may be modified in which the electric conductor forming liquid is a surface modifying solution for surface modifying the inner wall of the grooves upon application into the grooves and the post-process involves carrying out an ion exchange reaction for accumulating atoms of a metal and depositing a thin layer of the metal in the grooves and then an electroless plating technique and/or an electro-plating technique for separating an electrically conductive material from the solution at the opening of the grooves for developing the pattern of electric conductor.

The wiring circuit board producing method according to any of the preceding features may be modified in which the electric conductor forming liquid is a liquid electric conductor which is solidified to develop the pattern of electric conductor and the post-process involves repeating two or more times the application and drying or heating of the electric conductor forming liquid alternately.

The grooves may preferably be patterned by a material removing technique. Alternatively, the grooves may be patterned by an offset stamping technique so that their inner wall has at least partially rough surfaces thereof provided continuously and lengthwisely.

The wiring circuit board producing method according to any of the preceding features may further be modified wherein the grooves are classified into a first groove which incorporates a primary part of the pattern of electric conductor and a second groove which is arranged to surround a feeder from which the electric conductor forming liquid is introduced, the two, first and second, grooves being communicated to each other. Alternatively, the grooves may be classified into a first groove which incorporates a primary part of the pattern of electric conductor and a second groove which is arranged to surround a feeder from which the electric conductor forming liquid is introduced, the two, first and second, grooves being communicated to each other, and the first groove is further communicated with a third groove which is also surrounded by the second groove. Furthermore, the grooves may be classified into a first groove which incorporates a primary part of the pattern of electric conductor and is further communicated with a plurality of grooves provided adjacent to one another at the feeder. Favorably, the electric conductor forming liquid may be supplied to the feeder with the use of an ink jet or a dispenser.

A wiring circuit board produced by the wiring circuit board producing method according to any of the preceding features is characterized in that the electric conductor forming liquid is at least partially overlapped at its connecting portion to a mounted component and/or another substrate with the feeder. The wiring circuit board may be modified in which the substrate consists of a first substrate and a second substrate connected to each other, the first substrate having a bump provided thereon and the second substrate having a through hole provided therein across which the bump extends, and when the bump extends across the through hole, the first substrates and the second substrate are joined to each other at their respective electrodes, either the electrode on the first and or the electrode on the second substrate being located at the feeder. Alternatively, the substrate in the wiring circuit board may consist of a first substrate and a second substrate connected to each other, the first substrate having a bump provided thereon and the second substrate having a through hole provided therein across which the bump extends, and when the bump extends across the through hole, the first substrates and the second substrate are joined to each other at their respective electrodes, the two electrodes on the first and second substrates being located at the feeder and extended in different directions along the grooves when abutting each other.

The wiring circuit board produced by the wiring circuit board producing method according to any of the preceding features may be modified in which a receiver is provided at or adjacent to the feeder for positioning the connector portion. Alternatively, the receiver may be provided at or adjacent to the feeder for positioning the connector portion as having been shaped at the same time when the first groove is provided. Moreover, the receiver may be provided at or adjacent to the feeder for positioning the connector portion as having been shaped by a printing technique. In addition, the feeder may be supplied with another electric conductor forming liquid which is higher in the affinity with the electric conductor forming liquid.

The present invention is directed towards a wiring circuit board which is produced by any of the preceding wiring circuit board producing methods.

### (Advantages of the Invention)

The wiring circuit board and the wiring circuit board producing method according to the present invention allow the electric conductor forming liquid to be inhibited from overflowing and turned to a high-density circuit of wiring. Particularly, the electric conductor forming liquid such as silver ink which is costly can be minimized in the consumption, thus contributing to the overall cost saving.

Other objects, features, and advantages of the present invention will be apparent from the following description in conjunction with the drawings.

### Brief Description of the Drawings

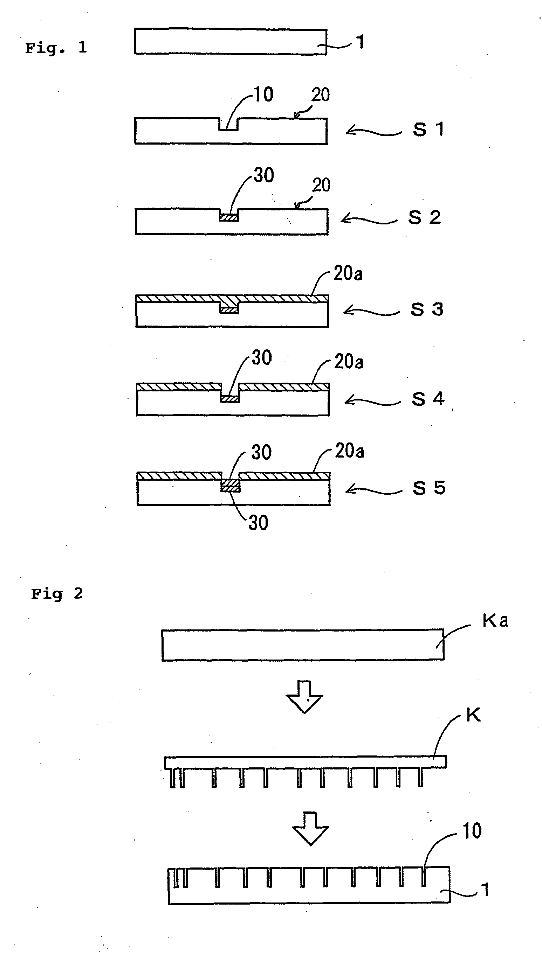

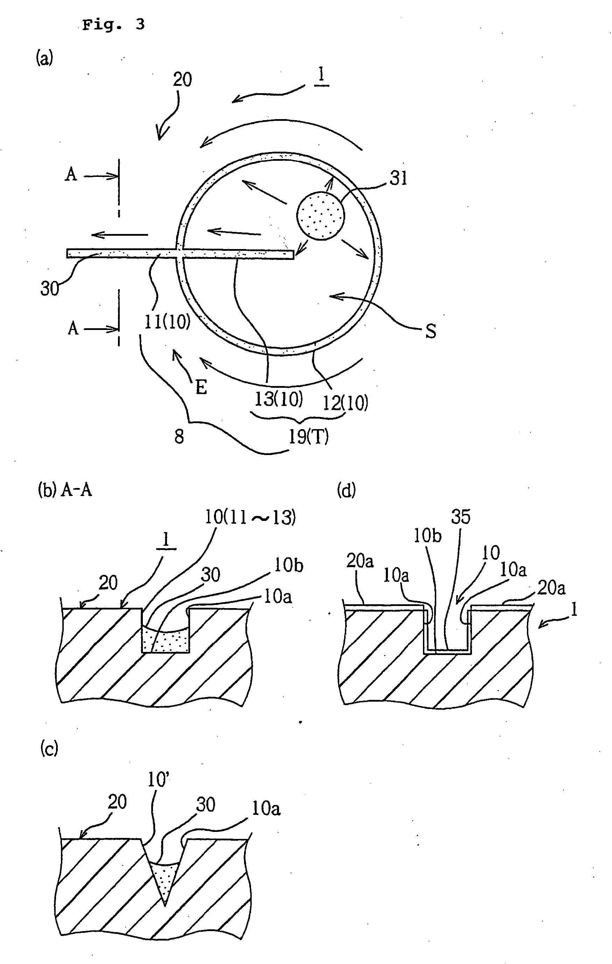

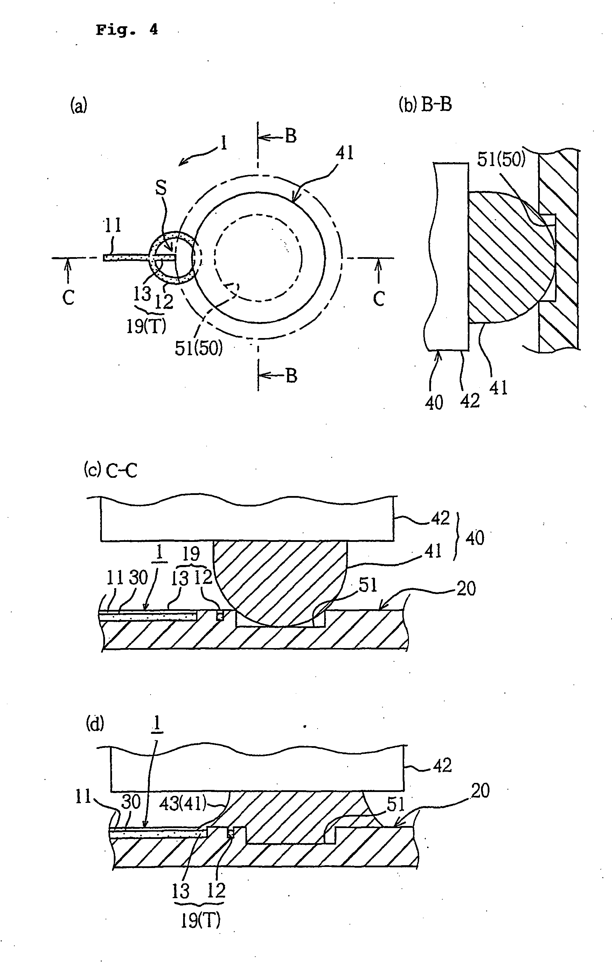

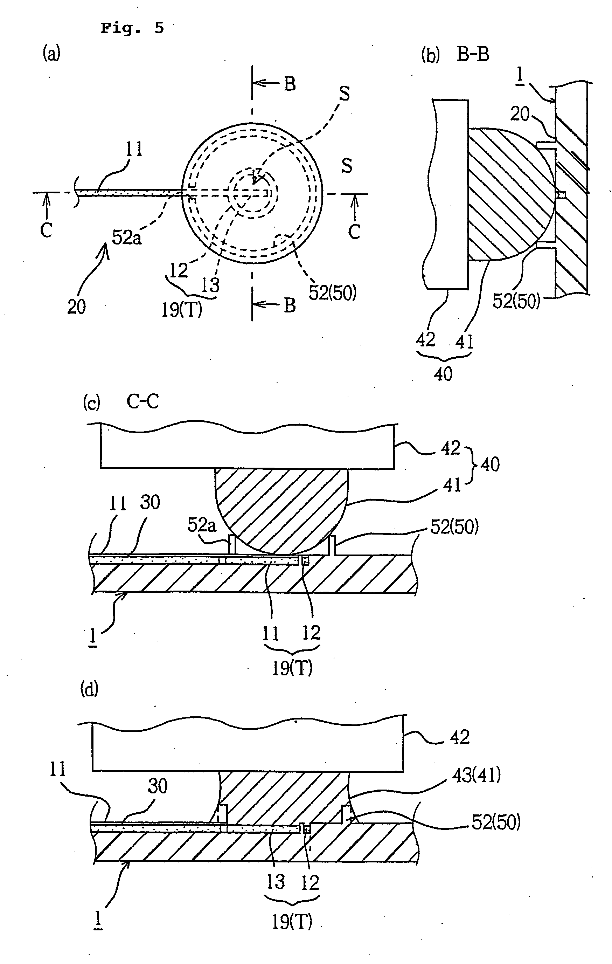

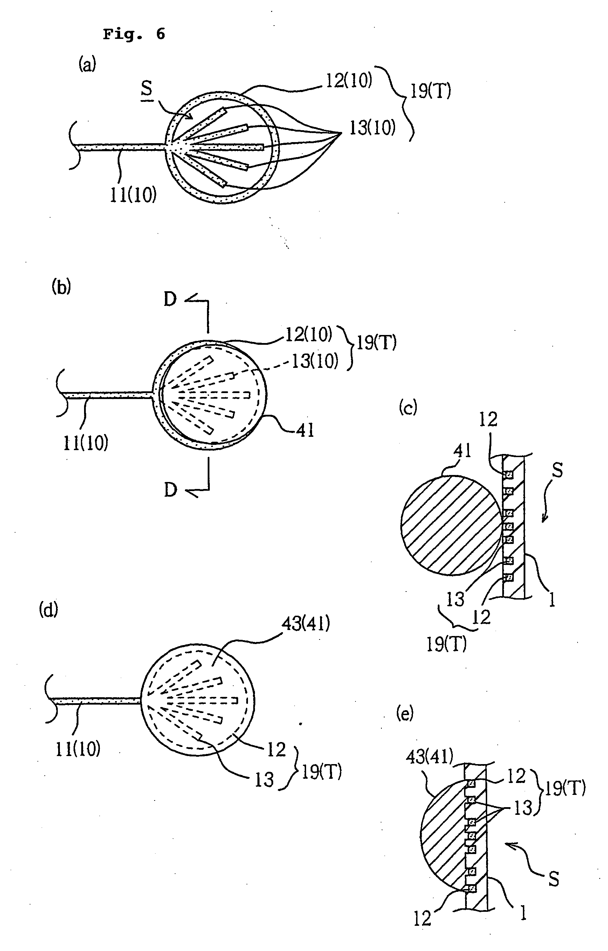

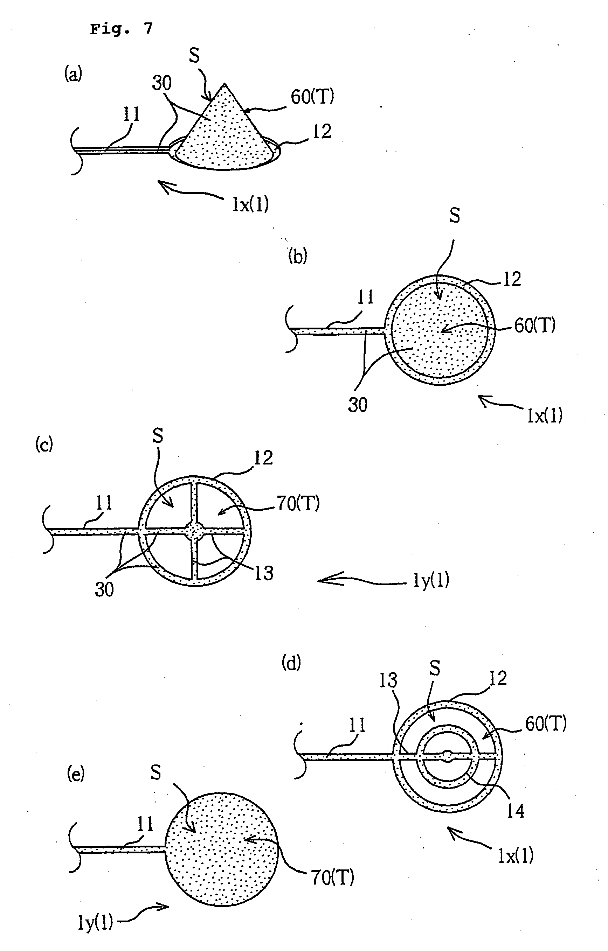

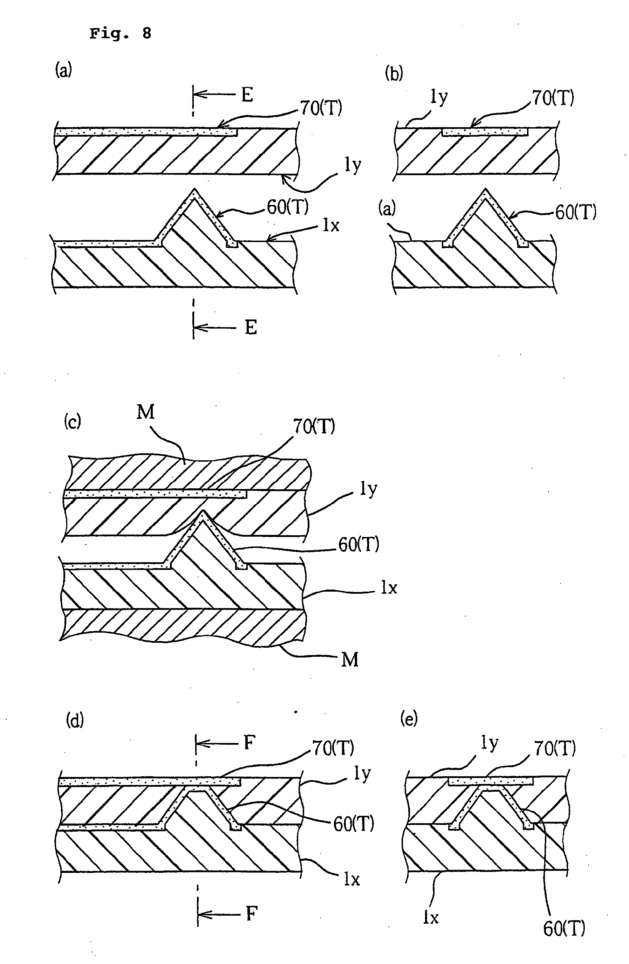

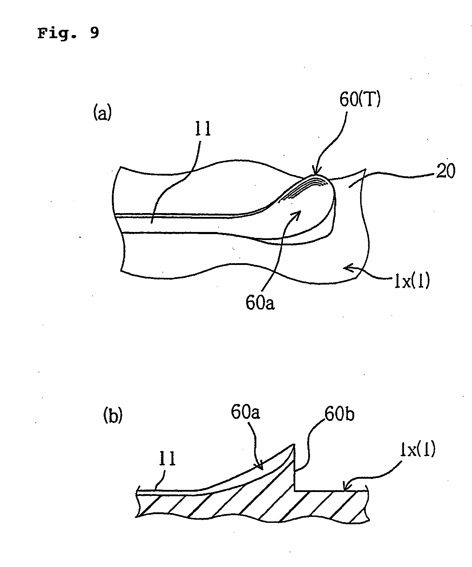

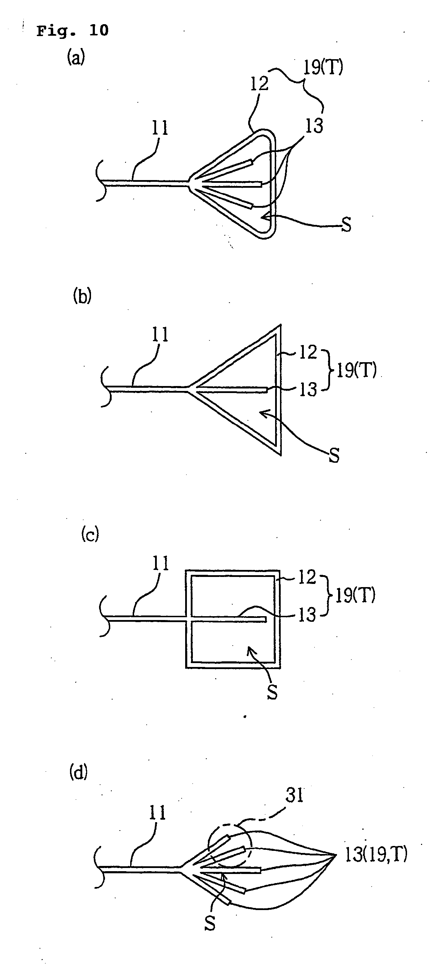

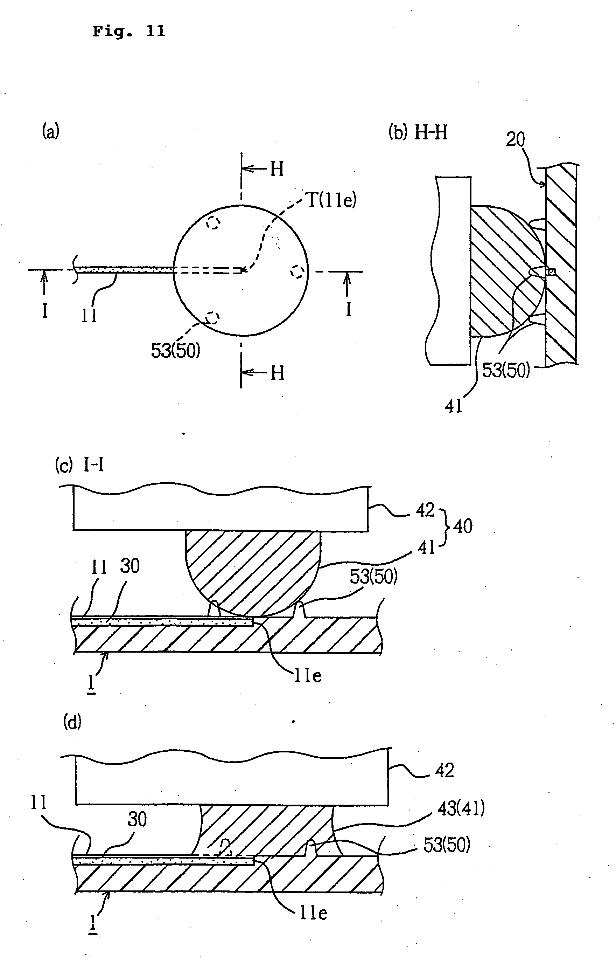

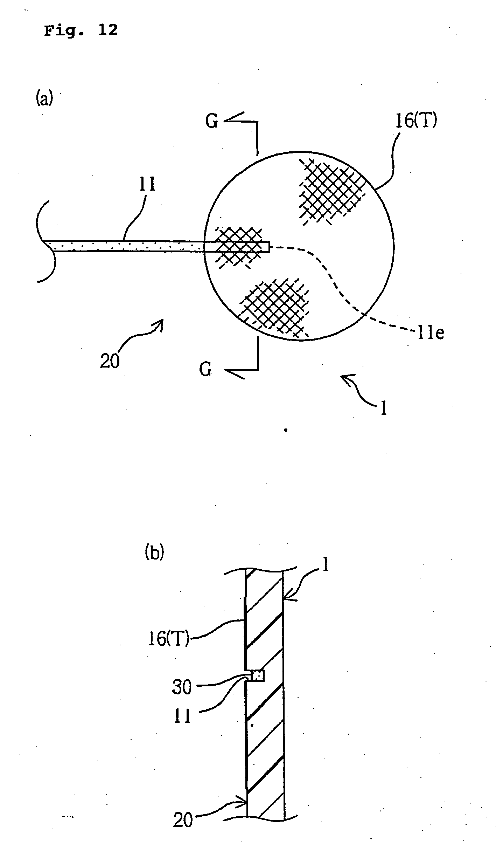

Fig. 1 is a cross sectional view of a substrate fabricated by steps of production according to the present invention; Fig. 2 is a cross sectional view showing the relationship between a stamping die and the substrate; Fig. 3a is an enlarged plan view showing a first, a second, and a third groove in the substrate according to the present invention; Fig. 3b is a cross sectional view taken along the line A-A of Fig. 3a; Fig. 3c is a cross sectional view taken along the line A-A of Fig. 3a showing a modification; Fig. 3d is a view similar to Fig. 3b showing a sixth embodiment; Fig. 4a is an enlarged plan view showing the relationship between the first, second, and third grooves in the substrate according to the present invention and a BGA soldering ball; Fig. 4b is a cross sectional view taken along the line B-B of Fig. 4a; Fig. 4c is a cross sectional view taken along the line C-C of Fig. 4a; Fig. 4d is a cross sectional view showing a melted state of the soldering ball; Figs. 5a to 5d are views similar to Figs. 4a to 4d showing another embodiment; Fig. 6a is a view similar to Fig. 3a showing another embodiment; Fig. 6b is a plan view showing the relationship between a first, a second, and a third groove in the substrate according to the present invention and a soldering ball; Fig. 6c is a cross sectional view of the same shown in Fig. 6b; Fig. 6d is a plan view showing a melted state of the soldering ball shown in Fig. 6a; Fig. 6e is a cross sectional view of the same shown in Fig. 6e; Fig. 7a is a perspective view of a bump provided on a lower substrate for connection; Fig. 7b is a plan view of the same shown in Fig. 7a; Fig. 7c illustrates a terminal provided above the same shown in Fig. 7b; Fig. 7d illustrates a modification of the same shown in Fig. 7a; Fig. 7e is a plan view of the terminal joined to the bump shown in Fig. 7d; Fig. 8a is a cross sectional view of the upper and lower substrates to be joined together by the bump; Fig. 8b is a cross sectional view taken along the line E-E of Fig. 8a; Fig. 8c illustrates the bump inserted further from the state shown in Fig. 8a; Fig. 8d illustrates a contact state ; Fig. 8e is a cross sectional view taken along the line F-F of Fig. 8d; Fig. 9a is a perspective view of a feeder showing a further embodiment; Fig. 9b is a longitudinal cross sectional view of the same shown in Fig. 9a; Figs. 10a to 10d are views similar to Fig. 6a showing further embodiments; Figs. 11a to 11d are views similar to Fig. 2 showing a further embodiment; Fig. 12a is a plan view of the substrate coated with another liquid electrical conductor; and Fig. 12b is a cross sectional view taken along the line G-G of Fig. 12a.

### Description of Numerals

1: substrate, 1x: first substrate, 1y: second substrate, 8: wiring circuit, 10: groove, 10a: side wall, 10b: bottom wall, 11: first groove, 11e: groove end, 12: second groove, 13: third groove, 14: annular groove, 16: printed electrode, 19: terminal groove, 20: substrate surface, 20a: repellent layer, 30: electrically conductive ink (liquid electric conductor), 31: ink drop (liquid electric conductor), 35: metal catalyst layer, 40: mounted component, 41:solderingball(connector),43:melted solder, 50: receiver, 51: ball hole, 52: ball cup, 52a: notch, 53: projection; 60: bump (projecting terminal), 60a: recess, 60b: raised portion, 70: connector terminal, S: feeder, T: terminal, K: stamping die, Ka: die material.

### Best Modes for embodying the Invention

The present invention will be described in more detail, referring to the accompanying drawings. Fig. 1 is a cross sectional view illustrating steps of a wiring circuit board producing method as the first embodiment of the present invention. The wiring circuit board producing method of this embodiment comprises a groove patterning step S1, an electric conductor forming liquid supplying step S2, a repellent layer providing step S3, a groove cleaning step S4, and another electric conductor forming liquid supplying step S5. Those steps are followed by a post-process step where the electric conductor forming liquid or conductive ink is heated and dried for solidification.

The material of a wiring substrate 1 in the embodiment is preferably, but not limited to, a not electrically conductive material which has OH groups exposed at the surface, as will be described later, and is subject to groove providing process for providing a pattern of grooves 10 with the use of offset-stamping or laser cutting. In case that the wiring substrate 1 is made of an electrically conductive material, it may be coated with a not electrically conductive material. Examples of the material include glass, epoxy resin, poly-urethane resin, silicone resin, di-aryl phthalate resin, formaldehyde resin, phenol resin, amino resin, ceramic, etc. The material may contain a release agent if desired.

The groove patterning step S1 is intended for providing a pattern of grooves in the wiring substrate 1 with the use of a laser cutting technique. This step may be implemented by at least one technique selected from a group of laser cutting, focused ion beam (FIB) cutting, machining, and electrical discharge cutting. Any combination of the techniques may preferably be used depending on the size of patterned grooves. The laser cutting is selected fromexcimer laser cutting, femto-second laser cutting, photolithographic and etching processing with Ar laser or He-Cd laser, and Si anisotropic etching.

The groove patterning step may also be implemented by any machining technique. The machining technique is selected frommilling, shaping, and so on. As compared with the machining, electric discharge cutting, and laser cutting, the FIB cutting can produce a smaller, sharper pattern of grooves which are converted into wirings.

The groove patterning step may be implemented by an offset-stamping technique using a stamping die K, as shown in Fig. 2. The material Ka is punched with the die K to have a desired pattern of grooves 10 in the wiring substrate 1.

The cross section of the grooves 10 may be arranged preferably of a four sided shape shown in Fig. 3b or a wedge shape shown in Fig. 3c. The wiring substrate 1 carries a high density wiring circuit where the width of each wiring 8 is not greater than 50 µm or preferably 40 µm or more preferably 30 µm. The aspect ratio (depth/width at the opening) of the grooves 10 is not smaller than preferably 0.5 or more preferably 1.0. The greater the aspect ratio, the more the cross sectional area of the grooves 10 can be increased regardless of the width of the wiring 8. If desired, the grooves 10 may partially be deepened down to the other side of the substrate 1. Each portion of the wiring 8 in the through groove 10 connects between the upper circuit and the lower circuit on the both sides of the substrate 1. The grooves 10 are not limited in both the depth and the shape.

The electric conductor forming liquid supplying step S2 is intended for filling the grooves 10 with a supply of ink 31 introduced by dropping into a feeder S. The action of filling may be implemented by an ink jet or a dispenser. More particularly, the electrically conductive ink 30 is applied into the grooves 10 by the effect of capillarity and heated up for curing. The action of heating is also repeated in the succeeding steps where the application or coating of other materials is conducted as will be explained in no more detail. As the electrically conductive ink 30 is heated up, it can be declined in the viscosity and thus increased in the speed of flowing. Also, the electrically conductive ink 30 may be attenuated in the speed of drying by increasing the pressure of a vaporized solvent under the atmosphere in a container where the wiring substrate 1 is placed.

The electrically conductive ink 30 to be applied as a conductor forming liquid into the grooves 10 is a dispersing material which is commonly used for a pattern of wiring on a wiring circuit board and may be selected from Au, Ag, Ag₂O, Pt, In, In-Ga alloy, Ga, RuO₂, IrO₂, OsO₂, MoO₂, ReO₂, WO₂, solder, Cu, and Au. The dispersing material is dispersed into a synthetic resin binder dissolved in a volatile solvent.

The grooves 10 according to the present invention are classified into a first groove 11 which extends throughout the wiring substrate 12 to have main lines, a second groove 12 which circles from one end or an intermediate of the first groove 11 to define the feeder S therein, and a third groove 13 which is surrounded by the second groove 12. The first groove 11, the second groove 12, and the third groove 13 are communicated with each other so that the supply of ink 31 introduced into the feeder S can flow via the second groove 12 and the third groove 13 into the first groove 11 without overflowing outwardly of the second groove 12 to develop a wiring circuit 8, as shown in Fig. 3. The illustration of a repellent layer 20a may be omotted in Figs. 3 to 12.

The wiring substrate 1 is then joined with a plurality of soldering balls 41 of each component 40 to be mounted. The feeder S is locatedadjacent to a receiver 50 for accepting each soldering ball 41. The receiver 50 is shaped of a ball recess 51 adjacent to the feeder S in which the soldering ball 41 is received and its positional relationship with the feeder S remains unchanged. The soldering balls 41 are coupled to the body 42 of the component for providing electrical connection. When the soldering balls 41 are heated and turned to melted forms 43, they are joined with the electrically conductive ink 30 in terminal grooves 19.

During the preparation of the wiring substrate 1, the ball recesses 51 are provided at the same time when the grooves 10 of the first to third types 11 to 13 are shaped. As the grooves 10 and the recesses 51 are provided at one time, their positional relationship remains intact without discrepancy and can be improved in the dimensional accuracy. This can be implemented by offset-stamping technique or laser cutting as described previously.

Then, the step S2 follows for introducing, as shown in Fig. 3, the supply of ink 31 into the feeder S in order to fill the grooves 10. The action of filling the grooves 10 is conducted using an ink jet or a dispenser. In this embodiment, the terminal end T is assigned to a combination of the second groove 12 and the third groove 13. The second groove 12 and the third groove 13 are thus referred to as two adjacent groove terminal ends.

At the repellent layer forming step S3, the wiring substrate 1 is coated at the surface 20 with a repellent layer 20a by a wet process (where a repellent layer forming liquid is applied and dried). The repellent layer 20a may be deposited by a dry process (in a vacuum).

The repellent layer 20a is made of a carbon fluoride compound such as expressed by Formula 1. The repellent layer 20a has a elastic, flexible molecular structure as being smoothed at the surface and covered entirely with fluorine, thus improving the contact angle. This allows the affinity with the electrically conductive ink 30 in a liquid form to remain low.

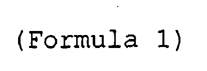

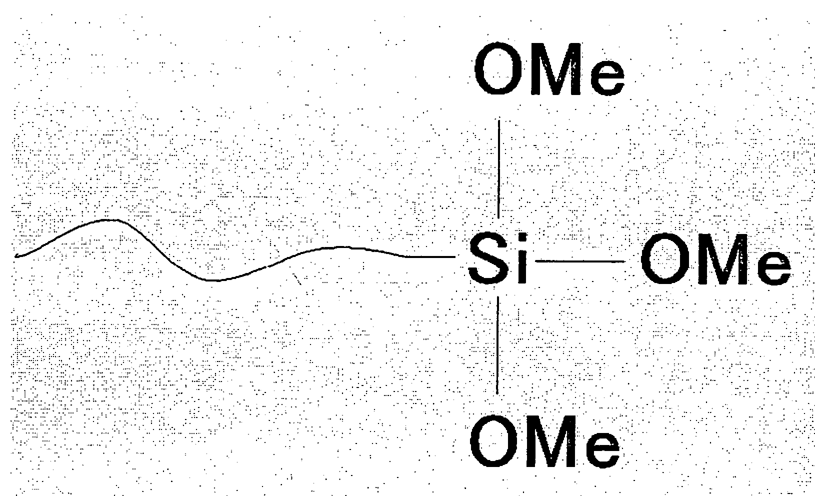

Alternatively, the repellent layer 20a may be made of another appropriate material expressed by Formula 2. The another material carries a -COOH base at the end and is singly applicable depending on the wiring substrate 1. When the wiring substrate 1 is made of a glass or silicon wafer, a silane coupling agent is needed as the re-process agent.

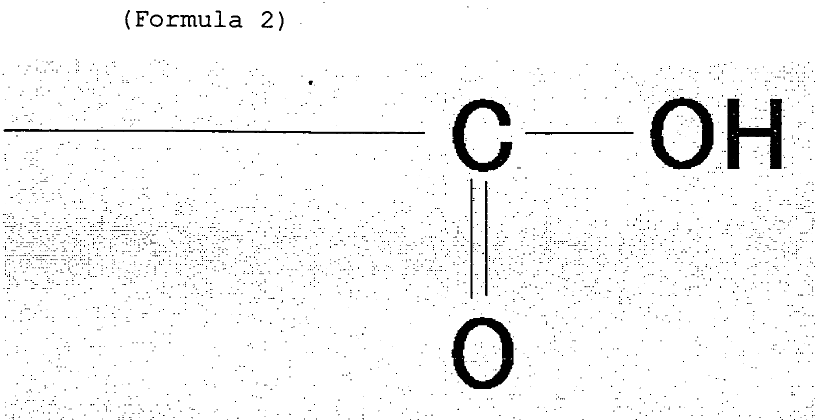

The step S4 follows for subjecting the wiring substrate 1 to ultrasonic cleaning in an alcohol. When the repellent layer 20a has been bonded with OH bases on the surface of the wiring substrate 1, it remains securely deposited on the surface of the wiring substrate 1. However, the electrically conductive ink 30 scarcely has the OH bases on the surface, thus permitting no bonding of the repellent layer 20a. This allows unwanted portions of the repellent layer 20a to be readily removed from the conductive ink 30 in the grooves 10 by rinsing.

At the step S5 similar to the step S2, the supply of ink 31 is introduced onto the feeder S to fill the grooves 10 with the electrically conductive ink 30. If the electrically conductiveink30flowsover the repellent layer 20a, its low affinity will inhibit the ink 30 from bonding with the repellent layer 20a, thus allowing the ink 30 to stay in the grooves 10. Accordingly, the method of the present invention is advantageous where the electrically conductive ink 30 is not spilled out but permits a resultant circuit to be developed at higher density while its consumption remains minimized. By repeating some times the introduction and heating of the electrically conductive ink 30 depending on the concentration of the forming liquid and the condition of the grooves 10, the patterned circuit on the surface 20 of the wiring substrate 1 can be increased in the thickness. Then, the soldering balls 41 of each component 40 are heated and fused for connecting with the circuit.

Another embodiment of the present invention will be described. Like components are denoted by like numerals as those of the first embodiment. The steps of the another embodiment which are different from those of the first embodiment will be described while the other steps are equivalent to those of the first embodiment.

In the second embodiment, the steps S2 and S4 of the first embodiment are replaced by a step S2a and a step S4a respectively. The method of producing a wiring circuit board of the second embodiment comprises the groove patterning steps S1, the temporal protective material supplying step S2a, the repellent layer forming step S3, the temporal protective material removing step S4a, and the electric conductor forming liquid supplying step S5.

The step 2a is intended for filling the grooves 10 with a temporal protective material liquid which is then removed at Step S4a. The temporal protective material inhibits the repellent liquid layer from being deposited in the grooves 10, the allowing the grooves 10 to be filled with the electric conductor forming liquid. The temporal protective material may be a polyvinyl alcohol solution or any other low-volatile solvent which is as low as not higher than 20 cP in the viscosity (at 20°C).

A third embodiment of the present invention will also be described where the step S2 of the first embodiment is replaced by a step S2b. The method of producing a wiring circuit board of the third embodiment comprises the groove patterning steps S1, the protective material supplying step S2b, the repellent layer forming step S3, the groove cleaning step S4, and the electric conductor forming liquid supplying step S5.

The protective material supplying step 2b is intended for filling the grooves 10 with a protective material which has a higher level of the affinity with the electrically conductive ink 30, thus ensuring the same advantage as of the step S2. The protective material may be equal to a binder in the electrically conductive ink 30. For example, the binder is a thermoset resin material provided as Ag Nano-paste from Harima. Since the protective material is higher in the affinity with the electrically conductive ink 30, it can protect the grooves 10 from deposition of the repellent layer 20a in the same manner as of the first embodiment. Accordingly, when the electrically conductive ink 30 is applied as the electric conductor forming liquid to fill the grooves 10, it can be prevented from overflowing and minimized in the consumption.

A forth embodiment of the present invention will be described where the step S3 of the first embodiment precedes the step S1 while the two other steps S2 and S4 are eliminated. The method of producing a wiring circuit board of the fourth embodiment comprises the repellent layer forming step S3, the groove patterning step S1, and the electric conductor forming liquid supplying step S5.

The groove patterning step S1 employs a laser cutting or an offset-stamping technique for removing the repellent layer from the grooves, thus allowing the grooves to be readily filled with the electric conductor forming liquid without difficulty. In the step S1, when the grooves 10 have been provided in the surface of the wiring substrate 1 by, e.g., laser cutting, amounts of debris remain left on the surface of the wiring substrate 1. The debris may be removed by air blowing, ultrasonic cleaning, or methanol rinsing. The generation of debris about the grooves 10 may be avoided when the wiring substrate 1 is covered at the surface with a thin sheet of film before the action of laser cutting starts.

A fifth embodiment of the present invention will now be described where the two steps S2 and S4 of the first embodiment are eliminated. The method of producing a wiring circuit board of the fifth embodiment comprises the groove patterning step S1, the repellent layer forming step S3, and the electric conductor forming liquid supplying step S5. In the step S1, the grooves 10 in the wiring substrate 1 are modified to have at least rough surfaces provided at the inner wall thereof continuously and lengthwisely: for example, a side 10a or a bottom 10b or both sides 10a and a bottom 10b as shown in Figs. 3b and 3c.

The rough surfaces at the inner wall of the grooves 10 may be shaped by laser cutting or offset-stamping. This allows the electric conductor forming liquid or the electrically conductive ink 30 to remain securely distributed in the grooves 10 as secured by the effect of the continuous rough surfaces at the inner wall of the grooves 10. In collaboration with the effect of the repellent layer 20a provided at the step S3, the action of the rough surfaces can inhibit the electrically conductive ink 30 from overflowing when being introduced into the grooves 10 at the succeeding step S5, hence eliminating any disconnection in the patterned circuit of the electrically conductive ink 30.

A sixth embodiment of the present invention will be described where the electrically conductive ink 30 is replaced by an electroless plating catalyst containing solution as the electric conductor forming liquid. The grooves 10 are filled with the electroless plating catalyst containing solution by the action of capillarity. Then, a post-process follows for separating an electrically conductive material from the electroless plating catalyst containing solution in the grooves 10 by another electroless plating action or an electro-plating action after the electroless plating to deposit the patterned circuit along the opening of the grooves. The post-process is preceded by the electric conductor forming liquid supplying step S5 of the third or fourth embodiment and comprises a metal catalyst separating step S6, a plating catalyst removing step S7, and a plating depositing step S8. This may also be implemented as the post-process following the steps of any of the first to third embodiment, depending on the combination of applicable components in the solution.

The metal catalyst separating step S6 is intended for improving the catalytic function after the application of the electroless plating catalyst containing solution. This action is triggered by exposing the electroless plating catalyst containing solution to a reducing atmosphere produced by drying or illumination of light, thus separating and depositing a metal catalyst 35 on the sides 10a and bottom 10b at the grooves 10.

The electroless plating catalyst containing solution may be a metal ion containing solution or a metal complex solution in which Pd or Pt is contained as the catalyst. The catalyst containing solution may be preferably of a photosensitive type when the illumination of light is used after the patterning step. Alternatively, the solution may be a commercially available catalyst solution used in one-pack technique when the exposure to a reducing atmosphere is employed. The material for producing the repellent layer is identical to that of the previous embodiments.

The metal catalyst separating step S6 permits the substrate to be exposed to the illumination of light or the reducing atmosphere for separating from the electroless plating catalyst containing solution and depositing the metal catalyst on the sides 10a and the bottom 10b at the grooves 10, thus improving the catalytic function. More specifically, the substrate on which a pattern of the electroless plating catalyst containing solution is provided in the grooves is exposed to, e.g., ultraviolet light or an ammonium atmosphere as the reducing atmosphere. The conditions for illumination of the ultraviolet light and exposure to the reducing atmosphere may be determined depending on the composition of the electroless plating catalyst containing solution.

The plating catalyst removing step S7 is added, if desired, for removing undesired portions of the electroless plating catalyst containing solution from the grooves after the metal catalyst separating step in order to improve the deposition of plating separation. For example, the action of rinsing with water may be used for removing the remaining of the electroless plating catalyst containing solution.

The plating depositing step S8 is intended for depositing an electrically conductive material at the opening of the grooves, where the metal catalyst has been separated, by another electroless plating action or an electro-plating action after the electroless plating. Preferably, the another electroless plating action may be used because its number of steps is smaller. The electrically conductive material to be deposited may be a metal selected from copper, silver, gold, platinum, and nickel. The plating action is carried out under known conditions anticipated by those who skilled in the art. A typical plating action is known where the substrate is immersed in a plating solution containing one of the above described metals until a pattern of the metal is deposited in the grooves from its opening to the bottom.

When an electric circuit made of the electrically conductive material has been developed in the grooves of the substrate, its wiring circuit board is finished. In this embodiment, the repellent layer also allows the electroless plating catalyst containing solution to be favorably distributed into the grooves for patterning without overflowing.

A seventh embodiment of the present invention will be described where the electrically conductive ink 30 is replaced by a surface modifying solution, such as potassium hydroxide (KOH), as the electric conductor forming liquid. The grooves are filled up with the surface modifying solution by the action of capillarity. Then, a post-process follows for separating an electrically conductive material from the surface modifying solution in the grooves 10 by another electroless plating action or an electro-plating action after the electroless plating to deposit the patterned circuit along the opening of the grooves. The post-process similar to that of the sixth embodiment is preceded by the electric conductor forming liquid supplying step S5 of the third or fourth embodiment and comprises amodifying solution removing step S10, an ion exchange reacting step S11, a copper thin layer depositing step S12, and a plating depositing step S13. This may also be implemented as the post-process following the steps of any of the first to third embodiment, depending on the combination of applicable components in the solution.

The substrate made of polyimide on which the repellent layer and the grooves are provided has a chemical composition expressed by Formula 3. The substrate is rinsed by ultrasonic cleaning, filled at the grooves with a potassium hydroxide solution at the electric conductor forming solution supplying step S5, and subjected to a surface modifying process. After the surface modifying process, the composition of the substrate is turned to as expressed by Formula 4. After a predetermined length of time, the surface modifying process is closed by rinsing the substrate with water at the surface modifying solution removing step S10.

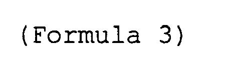

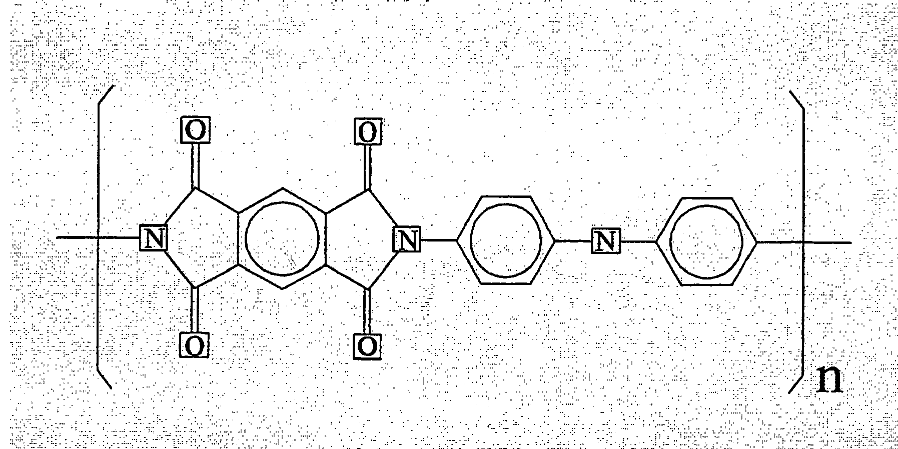

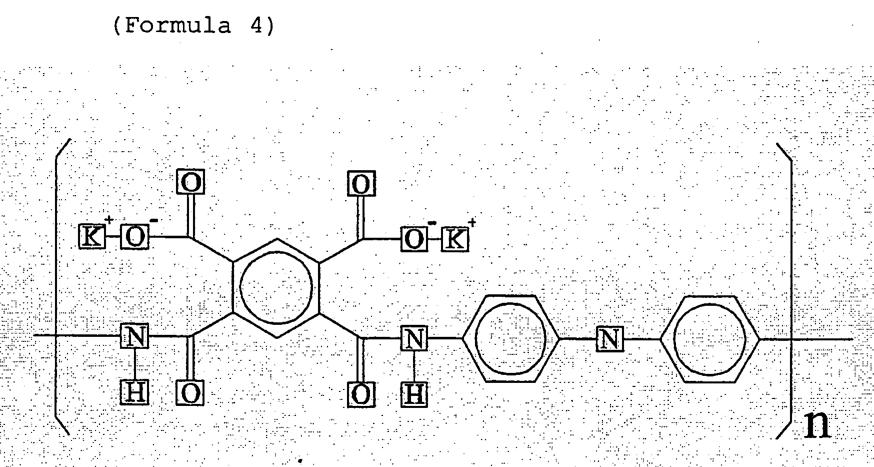

The ion exchange reacting step S11 follows for immersing the surface modified polyimide substrate into a copper sulfate (CuSO₄). By the reaction of ion exchange expressed by Formula 5, copper ions are accumulated on the inner wall at the grooves of the polyimide substrate.

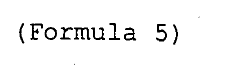

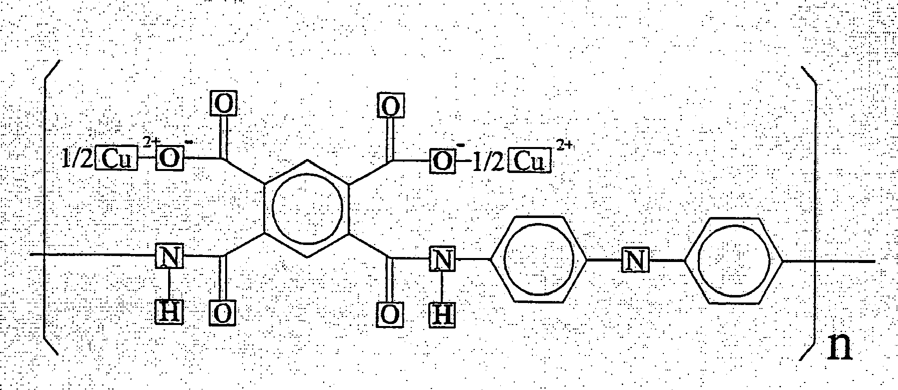

This is followed by the copper thin film depositing step S12 where the substrate on which the copper ions are accumulated is immersed into a sodium borohydride water solution or a di-methyl amine borane (DMAB) water solution to deposit a thin layer of copper at the opening of the grooves. Alternatively, the substrate may be immersed into an anatase type TiO₂ colloid solution to aggregate a photo-catalyst in the grooves and then exposed to ultraviolet light for triggering a reducing reaction by which a thin layer of copper is deposited in the grooves . The thin layer is then thickened to a patterned circuit through an electroless copper plating action or a copper electro-plating action, similar to the action in the sixth embodiment.

The electric conductor forming liquid in the seventh embodiment is not limited to the potassiumhydroxide solution but may be any other solution, e.g., where potassium hydroxide is dissolved in ethylene glycol or tetra-decane. Alternatively, as different from the claims, the electric conductor forming liquid supplying step S5 may be carried out with not the electric conductor forming liquid introduced by dropping to the feeder but the substrate immersed entirely into the electronic conductor forming liquid for surface modification over the area other than the area coated with the repellent layer.

Further embodiments will be described where the grooves are arranged to specific shapes. According to an eighth embodiment of the present invention shown in Fig. 5, the terminal end T of the grooves 10 is located just beneath the soldering ball 41 while the receiver 50 is implemented by an annular ball cup 52 which projects upwardly from the surface 20 of the substrate 1 as is located about the terminal end T. The ball cup 52 has a notch 52a provided therein across which the first groove 11 extends so that the electrically conductive ink 30 introduced into the feeder S runs across the notch 52a to the first groove 11. The action of fusing the soldering ball 41 to a melted form 43 for bonding with the terminal end T of the circuit is identical to that of the first embodiment.

According to a ninth embodiment of the present invention shown in Fig. 6, two or more of the third grooves 13 are provided radially in the second circular groove 12. Since the terminal end T is substantially equal in the diameter to the soldering ball 41 (a melted form 43), it can prevent the melted form 43 of the soldering ball 41 from overflowing across the second groove 12.

According to a tenth embodiment of the present invention shown in Figs. 7 and 8, a bump 60 is provided as the terminal end T on a first substrate 1x while a connector 70 is provided as the terminal end T on a second substrate ly, whereby the bump 60 is joined across the second substrate ly to the connector 70. In this embodiment, the bump 60 on the first substrate 1x is coated entirely with the electrically conductive ink 30 while the connector 70 on the second substrate ly has a spoke pattern of the third grooves 13 provided therein to locate in the second circular groove 12 and filled with the ink 30 thus forming the terminal end T. Alternatively, the first substrate 1x has an annular groove 14 provided therein to communicate with the third groove 13 as best shown in Fig. 7d, thus forming the terminal end T. Also, the connector 70 on the second substrate 1y remains unchanged in the shape as shown in Fig. 7c or modified to such a full shape as shown in Fig. 7e. This allows the annular groove 14 in the first substrate 1x to intersect at right angles to and communicate with the third groove 13 in the second substrate 1y.

The bump 60 on the first substrate 1x may also be modified to any applicable shape such as a spoon shape shown in Fig. 9. This shape incorporates a combination of a bowl-like recess 60a extending to the first groove 11 and a raised portion 60b on the surface 20 of the first substrate 1x. When the electrically conductive ink 30 is introduced into the spoon-like recess 60a, it can readily run down to the first groove 11.

Furthermore, the terminal end T may be modified to any favorable shape. For example, Fig. 10a illustrates a triangle form of the second groove 12 at each vertex rounded. Also, the second groove 12 may be arranged to a triangle form or a square form as shown in Figs. 10b or 10c respectively, depending on the size of the feeder S. Fig. 10d illustrates the third groove 13 divided into several "adjacent branches" for the feeder S which are communicated with the first groove 11. When the terminal grooves 19 are filled with the supplies 34 of the electrically conductive ink 30, they serve as the terminal end T.

Fig. 11 illustrates another modification of the terminal end T. The first groove 11 is filled from one end 11e with the electrically conductive ink 30 introduced from the feeder S which is provided at the right but not shown in Fig. 11a. The one end 11e is surrounded by three projections 53 provided on the surface 20 of the substrate 1 for accepting the soldering ball 41, thus forming the receiver 50. The projections 53 may simply be fabricated by the previous described technique such as die forming or a printing technique such as silk screen printing.

Fig. 12 is similar to Fig. 11, illustrating a further modification where a spot of the electrically conductive ink 30 is printed down to develop a printed electrode 16 about the one end 11e thus forming the terminal T.

The embodiments and their modifications may be implemented in any desired combination. Also, the supply of the electrical conductor forming liquid or electrically conductive ink 30 is not limited to the dropping action.

### Industrial Applications

The present invention is directed towards a wiring circuit board producing method and a wiring circuit board produced by the method such as a high-density circuit board. When the width of the grooves is smaller than that of an feeding outlet for the liquidelectric conductor, the present invention is applicable to a board if which the wiring is greater in the width than that of the high-density circuit board. The substrate may be arranged of a planar form or a three-dimensional form while the grooves are provided in an arcuate surface.

## Claims

1. A wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor, **characterized by**: patterning the grooves in the surface of the substrate; filling the grooves with the electric conductor forming liquid; providing on the surface of the substrate a repellent liquid layer which is lower in the affinity with the electric conductor forming liquid; cleaning at least the grooves; and applying further the electric conductor forming liquid into the grooves.

2. A wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor, **characterized by**: patterning the grooves in the surface of the substrate; applying a temporal liquid protective material into the grooves; providing on the surface of the substrate a repellent liquid layer which is lower in the affinity with the electric conductor forming liquid; cleaning at least the grooves to remove a portion of the repellent liquid layer provided over the temporal protective material; and filling the grooves with the electric conductor forming liquid.

3. A wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor, **characterized by**: patterning the grooves in the surface of the substrate; applying into the grooves a protective material which is higher in the affinity with the electric conductor forming liquid; providing on the surface of the substrate a repellent liquid layer which is lower in the affinity with the electric conductor forming liquid; cleaning at least the grooves; and applying further the electric conductor forming liquid into the grooves.

4. A wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor, **characterized by**: providing on the surface of the substrate a repellent liquid layer which is lower in the affinity with the electric conductor forming liquid; patterning the grooves in the surface of the substrate; and filling the grooves with the electric conductor forming liquid.

5. A wiring circuit board producing method of introducing an electric conductor forming liquid into the grooves provided in a substrate, distributing the electric conductor forming liquid further along the grooves by the action of capillarity, and subjecting the substrate to a post-process for developing a pattern of conductor, **characterized by**: patterning the grooves in the surface of the substrate so that their inner wall has at least partially rough surfaces thereof provided continuously and lengthwisely; providing on the surface of the substrate a repellent liquid layer which is lower in the affinity with the electric conductor forming liquid; and filling the grooves with the electric conductor forming liquid.

6. A wiring circuit board producing method according to any of claims 1 to 5, wherein the electric conductor forming liquid is an electroless plating catalyst containing solution and the post-process involves separating an electrically conductive material from the solution at the opening of the grooves by an electroless plating technique for developing the pattern of electric conductor.

7. A wiring circuit board producing method according to claim 6, wherein the post-process involves separating an electrically conductive material from the solution at the opening of the grooves by a combination of the electroless plating technique and an electro-plating technique following the electroless plating technique for developing the pattern of electric conductor.

8. A wiring circuit board producing method according to any of claims 1 to 5, wherein the electric conductor forming liquid is a surface modifying solution for surface modifying the inner wall of the grooves upon application into the grooves and the post-process involves carrying out an ion exchange reaction for accumulating atoms of a metal and depositing a thin layer of the metal in the grooves and then an electroless plating technique and/or an electro-plating technique for separating an electrically conductive material from the solution at the opening of the grooves for developing the pattern of electric conductor.

9. A wiring circuit board producing method according to any of claims 1 to 5, wherein the electric conductor forming liquid is a liquid electric conductor which is solidified to develop the pattern of electric conductor and the post-process involves repeating two or more times the application and drying or heating of the electric conductor forming liquid alternately.

10. A wiring circuit board producing method according to any of claims 1 to 5, wherein the grooves are patterned by a material removing technique.

11. A wiring circuit board producing method according to any of claims 1 to 5, wherein the grooves are patterned by an offset stamping technique so that their inner wall has at least partially rough surfaces thereof provided continuously and lengthwisely.

12. A wiring circuit board producing method according to any of claims 1 to 5, wherein the grooves are classified into a first groove which incorporates a primary part of the pattern of electric conductor and a second groove which is arranged to surround a feeder from which the electric conductor forming liquid is introduced, the two, first and second, grooves being communicated to each other.

13. A wiring circuit board producing method according to any of claims 1 to 5, wherein the grooves are classified into a first groove which incorporates a primary part of the pattern of electric conductor and a second groove which is arranged to surround a feeder from which the electric conductor forming liquid is introduced, the two, first and second, grooves being communicated to each other, and the first groove is further communicated with a third groove which is also surrounded by the second groove.

14. A wiring circuit board producing method according to any of claims 1 to 5, wherein the grooves are classified into a first groove which incorporates a primary part of the pattern of electric conductor and is further communicated with a plurality of grooves provided adjacent to one another at the feeder.

15. A wiring circuit board producing method according to any of claims 12 to 14, wherein the electric conductor forming liquid is supplied to the feeder with the use of an ink jet or a dispenser.

16. A wiring circuit boardproducedby the wiring circuit board producing method defined in any of claims 12 to 14, **characterized in that** the electric conductor forming liquid is at least partially overlapped at its connecting portion to a mounted component and/or another substrate with the feeder.

17. A wiring circuit board produced by the wiring circuit board producing method defined in any of claims 12 to 14, **characterized in that** the substrate consists of a first substrate and a second substrate connected to each other, the first substrate having a bump provided thereon and the second substrate having a through hole provided therein across which the bump extends, and when the bump extends across the through hole, the first substrates and the second substrate are joined to each other at their respective electrodes, either the electrode on the first and or the electrode on the second substrate being located at the feeder.

18. A wiring circuit board produced by the wiring circuit board producing method defined in any of claims 12 to 14, **characterized in that** the substrate consists of a first substrate and a second substrate connected to each other, the first substrate having a bump provided thereon and the second substrate having a through hole provided therein across which the bump extends, and when the bump extends across the through hole, the first substrates and the second substrate are joined to each other at their respective electrodes, the two electrodes on the first and second substrates being located at the feeder and extended in different directions along the grooves when abutting each other.

19. A wiring circuit board produced by the wiring circuit board producing method defined in any of claims 12 to 14, **characterized** further by a receiver provided at or adjacent to the feeder for positioning the connector portion.

20. A wiring circuit board produced by the wiring circuit board producing method defined in any of claims 12 to 14, **characterized** further by a receiver provided at or adjacent to the feeder for positioning the connector portion as having been shaped at the same time when the first groove is provided.

21. A wiring circuit board produced by the wiring circuit board producing method defined in any of claims 12 to 14, **characterized** further by a receiver provided at or adjacent to the feeder for positioning the connector portion as having been shaped by a printing technique.

22. A wiring circuit board produced by the wiring circuit board producing method defined in any of claims 12 to 14, **characterized in that** the feeder is coated with another electric conductor forming liquid which is higher in the affinity with the electric conductor forming liquid.
